# EUROPEAN PATENT APPLICATION

(11) **EP 0 654 745 A2**
(43) Date of publication of application: **24.05.1995**
(21) Application number: 94308233.9
(22) Date of filing: 09.11.1994
(51) Int. Cl.: G06F 17/50, G06T 11/00

(54) **Graphical display system for routing and repartitioning circuits during layout**

(30) Priority: 18.11.1993 US 154769
(71) Applicant: AT&T Corp., New York, NY 10013-2412 (US)
(72) Inventor: Fechter, Robert J., Whitehouse Station, New Jersey 08889 (US)
(74) Representative: Buckley, Christopher Simon Thirsk

(57) **Abstract**

A graphical display which is part of a computer aided design system conveys information, such as component packaging information related to logic elements to the designer. The designer can then use this information and the graphical display to communicate requests to the system for design changes, such as changing wiring connections to take advantage of the component packaging information.

The graphical display system enables improved user and system interaction generally, and more specifically, enables electronic circuit designers to perform tasks such as the assignment and reassignment of circuit elements to physical packages within a physical circuit design system without seeking information from outside the system.

## Description

### Field of the Invention

The present invention relates to improved graphical display systems and methods enabling improved user and system interaction. More particularly, the present invention relates to a graphical display system to aid computer aided circuit design tasks, such as in the assignment and reassignment of circuit elements to physical packages (subsequently referred to as partitioning and repartitioning) while using a computer aided design (CAD) system (subsequently referred to as the design system).

### Background of the Invention

A printed circuit board (PCB) is a board on which a variety of electrical components may be mounted. These various components are connected by conductive strips which are printed on the PCB. A PCB may have conductive strips printed on one side of the board (single-sided PCB), or may have conductive strips on both sides of the board (double-sided PCB). There are also multilayer PCBs, in which conductive strips are located on several insulated internal layers.

A key goal of a physical layout designer is the design of efficiently manufacturable PCBs that conform to specifications for circuit functionality and performance. The designer must determine the configuration of the PCB, including the location of circuit components, and the routing of the conductive strips which will connect the various circuit components.

The typical process of designing printed circuit boards involves a sequence of steps that may include design capture followed by design partitioning followed by physical layout. Design capture is the process of a circuit designer providing some specification of the components and behavior of a circuit. Most typically this is simple schematic capture, the process of defining a schematic diagram of the circuit which specifies the set of components or parts of the circuit as well as how they are to be logically interconnected. Other forms of design capture may include behavioral methods where the behavior of the circuit is described through a programming language or hardware description language. Synthesis tools are then typically used to transform this behavioral description of a circuit into a more conventional logical circuit description corresponding to a schematic diagram. Design capture is frequently performed in an unpartitioned mode, where circuit elements such as logic gates are used in the circuit specification without any reference to how they will be physically packaged. For example, dozens of inverters may be specified in the schematic without a description of what package they are to be contained in.

Design partitioning is the process of assigning logic gates or logic elements to physical packages. During design partitioning, various physical packages will be selected to house these logic elements. A common choice for inverters is a hex-inverter package which contains 6 inverters in a dual in-line pack (DIP) integrated circuit. Using such a package may be desirable as it will take up less space than six individual inverter packages. Typically, a circuit engineer will specify an initial partitioning based on packages having desirable physical and electrical properties. A circuit engineer will typically refer to specifications published by the package manufacturer for information on a package. Such publications contain information such as the type of elements contained within a package, the number of elements contained within a package, and the assignment of element pins to package pins.

During physical layout, a physical representation of the design is created that was specified by the circuit designer through a logical representation. The physical design process typically involves such steps as layout analysis, component placement, circuit repartitioning, and conductive path routing. During layout analysis, the circuit is analyzed to determine placement and routing strategies and look at repartitioning options. At this stage, an initial placement is typically performed assigning specific locations to pins on a PCB.

CAD tools for designing physical circuit layouts allow a circuit designer to physically position circuit components on a supporting structure and define the interconnecting conducting paths in accordance with a circuit schematic defined by the circuit designer. Prior art CAD systems used in the design of printed circuit boards allowed designers to view a physical layout showing the positioning of various components on the PCB. These systems did not allow a designer to see a functional view of the various components along with the physical view. A functional view is a graphical depiction of the design which differs from the physical layout in that functional attributes are emphasized. Functional views present functional data in the context of the physical layout. These views are most effective as an interactive and visual aid to partitioning, placement, and routing activities. Without the ability to obtain a functional view on the screen simultaneously with the physical layout, designers were forced to refer to external sources for such information, such as the schematic or component manufacturers published specification of packages.

This invention offers a more effective solution where the repartitioning is not only performed in the physical design system, but is done with graphical aids that substantially reduce the need to refer to external sources of information such as the schematic or component manufacturers published specification of packages.

### Summary of the Invention

This invention relates to an interactive graphical display system and method, and in particular to a system and method for the improved display of electronic circuit information. The invention aids electronic circuit designers in performing the assignment and reassignment of circuit elements to physical packages (i.e., partitioning and repartitioning) during the physical layout of a circuit board or package.

In accordance with the present invention, an interactive CAD physical circuit layout system includes graphical aids to permit interactive circuit repartitioning. During layout analysis the circuit is analyzed to determine placement and routing strategies and look at repartitioning options. Circuit elements or primitive components may be reassigned to different packages or repartitioned by means of the graphical features of the invention in order to improve the physical layout and improve the conductor routing according to user specified criteria. For example circuit elements may be moved from one package to another to relieve routing congestion by bringing circurt elements closer to the devices they are to be interconnected with.

In the CAD system embodying the invention, repartitioning is not only fully performed within the physical design system, but is done with graphical aids that substantially reduce the need to refer to external sources of information such as the schematic or component manufacturer's published specification of packages. These graphical aids allow for the simultaneous display of a functional view with the physical layout view. Data describing the component packages is included within a system database or accessed on line from an accessible stored database. The information specified includes physical package geometry (including length and width of package), number and location of component package pins, and the optional identification of power, ground, and unused pins. In addition, a description of each element contained in this package including the number of elements, the number of element pins, the association of element pins to component package pins, and optionally each element is defined as to name or type. No external, predefined geometric description is needed or used for the elements or the internal view of the elements within the component package. This is generated dynamically on demand when the component is displayed with this information requested. This geometric description is also saved for quick display when another request to display the same component is made at a later time. After a functional view is generated it may be used as a graphical interface for interactive pin and element swapping.

### Description of the Drawings

Fig. 1 shows a physical layout view of a portion of a circuit.

Fig. 2 shows a functional view of the physical layout shown in Figure 1.

Fig. 3 shows the physical layout view of the circuit of Figure 1 after a swap has been completed.

Fig. 4 shows a functional view of the circuit shown in Figure 3.

Fig. 5 shows a schematic of the components of the system of the present invention.

Fig. 6 shows the display of a functional view of a circuit in one portion of a graphical display monitor and a physical layout view in a separate portion of the graphical display monitor.

Fig. 7 shows a display on a graphical display monitor in which a functional view is superimposed on a physical layout view.

Fig. 8 shows a functional view including supplemental text.

Fig. 9 is a flow chart of the operation of the user interface.

Fig. 10 is a flow chart for the procedure for displaying component views.

Fig. 11 is a flow chart for the procedure for displaying part views.

Fig. 12 is a flow chart for the procedure of displaying net views.

Fig. 13 is a flow chart for the procedure of displaying region views.

Fig. 14 is a flow chart for the processing of swap requests.

Fig. 15 is a flow chart for the procedure of setting options.

Fig. 16 is a flow chart for the procedure of generating generic element views.

Fig. 17 shows the elements of an internal view of a package.

Fig. 18 shows a functional view of a dual in-line package which contains four AND gates.

Fig. 19 shows the geometric description of the package shown in Figure 18.

Fig. 20 shows the representation of a solder point in the geometric display.

Fig. 21 illustrates the graphical display of a 3 point route between an element pin and a package pin.

Fig. 22 shows an example of a spans display where the spans scale option is set to 100%.

Fig. 23 shows an example of a spans display where the spans scale option is set to a number less than 100%.

Fig. 24 illustrates the determination of whether a blockage exists in a functional view.

Fig. 25 illustrates the display of net graphics.

Fig. 26 shows a functional view of a single in-line package which contains three resistors.

Fig. 27 shows the geometric description of the package shown in Fig. 26.

Fig. 28 shows the elements of an internal view of a leaded chip carrier.

Fig. 29 shows a functional view of a leaded chip carrier which contains two flip-flops.

Fig. 30 shows the geometric description of the package shown in Fig. 29.

Fig. 31 shows an improved geometric description of the package shown in Fig. 29.

### Detailed Description

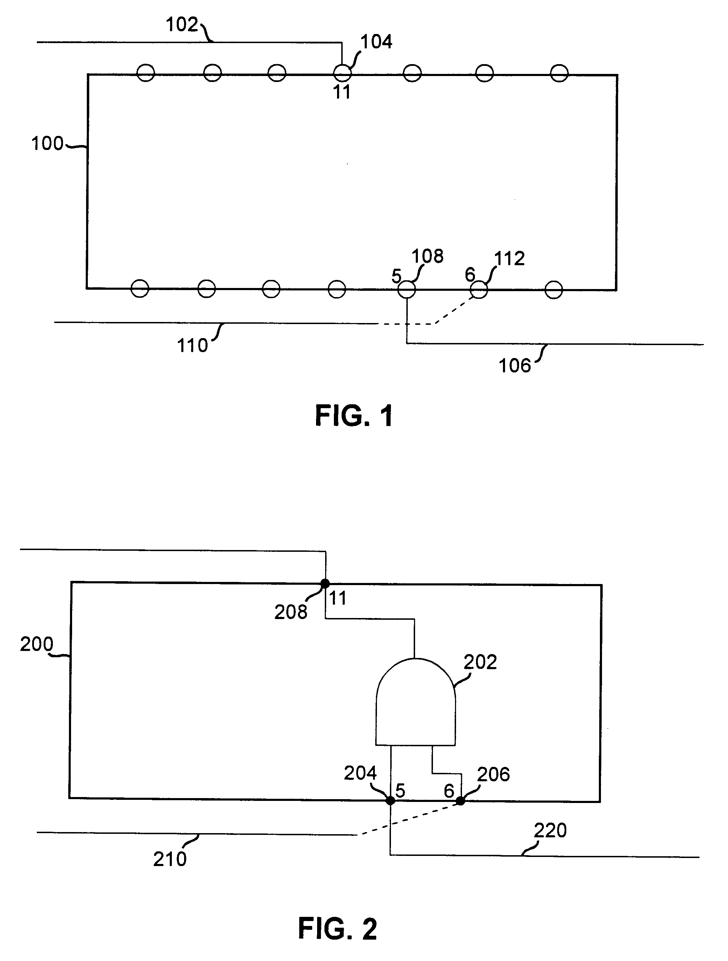

Circuit repartitioning involves swapping equivalent circuit elements between physical packages to improve the electrical performance or ability to layout the circuit. By moving circuit elements between packages, they may be brought closer to the devices they are to be interconnected with, thereby improving the speed of the circuit. In addition, swapping circuit elements may relieve routing congestion by bringing circuit elements closer to the devices they are to be interconnected with. An example of the benefit of circuit repartitioning may be illustrated by reference to Fig. 1.

Fig. 1 is an example of a physical layout view of a circuit in a CAD system. This view shows the physical component package 100 along with conductive strip routing. The lines 102, 106 and 110 represent the conductive strips on the PCB which are used to connect various electrical components. Here, the conductive strip 102 is connecting some element or elements, which are not currently displayed, with pin 11 104 of the component package 100. Similarly, conductive strip 106 is shown connecting some non-displayed element or elements to pin 5 108 of the component package 100. The display shows that the design calls for conductive strip 110 to be connected to pin 6 112 of the component package 100. However, assuming this is a single sided PCB, the path is blocked by conductive strip 106. This unconnected path is shown by a broken line in Fig. 1.

The physical layout designer has various options at this point to overcome the problem of being unable to connect conductive strip 110 to pin 6 112. One solution would be to use a discrete wire. This would allow conductive strip 110 to be physically laid over conductive strip 106 so that conductive strip 110 reaches pin 6 112. This would require some type of insulating device to be placed on the board so that conductive strip 110 could pass over conductive strip 106 without the two strips making electrical contact with each other. In terms of manufacturability, this is a less desirable solution in that it adds to the cost and complexity of the PCB manufacturing process and reduces reliability.

If Fig. 1 represented a two-sided PCB, or a multilayer PCB, a solution to the problem could be to reroute conductive strip 110 to another layer of the PCB in order to avoid conductive strip 106, and then to have conductive strip 110 return to be connected to pin 6 112. This rerouting can be accomplished using a "via", which is a conductive connection from one side of the board to another, or from one layer of the board to another. For example, a via could be a hole plated with metal from one side or layer of the board to another side or layer of the board. Like the discrete wire solution discussed previously, this too is a less desirable solution in that it adds to the cost and complexity of the PCB manufacturing process.

The benefit of circuit repartitioning becomes clear when compared to the solutions of using a discrete wire or rerouting the conductive strip to a different level. By swapping equivalent circuit elements, conductive strip routing can be simplified, and the manufacturability and reliability of the PCB can be improved. In order to repartition a circuit, a designer must know the functional layout of various component packages. For example, with the physical layout view of Fig. 1 alone, a circuit designer cannot determine whether any of the pins of the package 100 are swappable in order to complete the unrouted conductive strip.

Fig. 2 is a functional view of the physical layout view shown in Fig. 1. Fig. 2 shows a functional view of the part 200. This view shows that package pin 5 204 and package pin 6 206 are inputs to an AND gate 202, and that pin 11 208 is the output of the AND gate 202. Fig. 2 shows that the conductive strip represented by 210 is blocked by the conductive strip represented by 220. However, with the functional view it can be seen that package pin 5 204 and package pin 6 206 are both inputs to the AND gate 202. A circuit designer skilled in the art would realize that package pins 5 204 and 6 206 are swappable without changing the function of the circuit. Note that the physical layout view of Fig. 1 does not convey the functional information that Fig. 2 conveys.

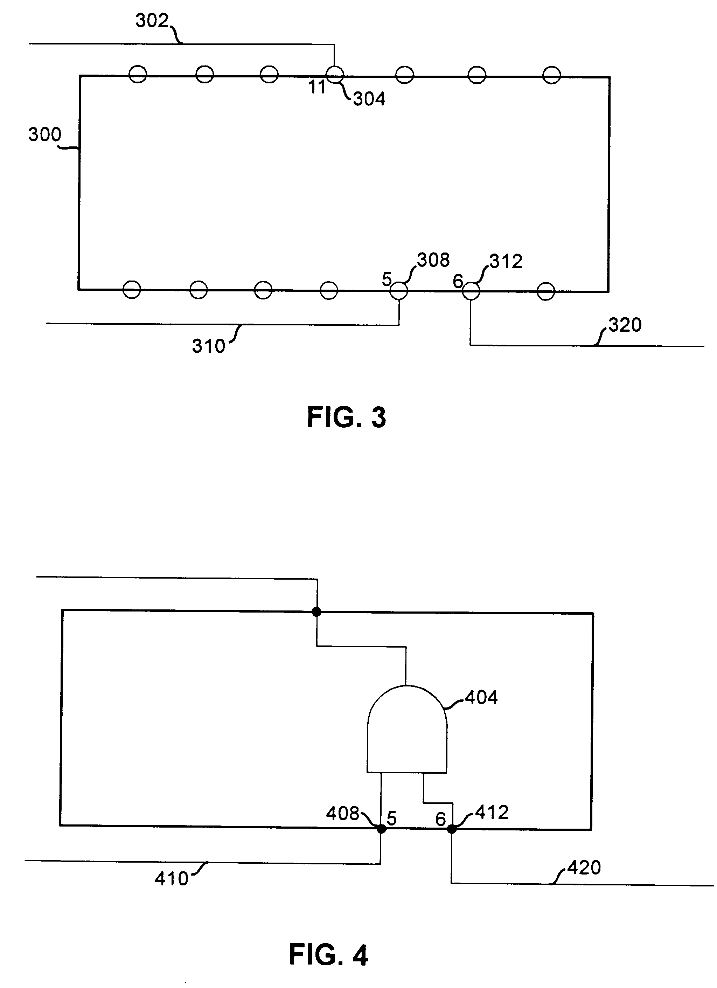

By swapping pins 5 and 6 there is no longer any blockage and conductive strips 210 and 220 can be completed. This is shown in Fig. 3 and Fig. 4. Fig. 3 shows the physical layout view after the swap has been completed. Conductive strip 310 is now connected to package pin 5 308. Conductive strip 320 is now connected to package pin 6 312. Conductive strip 302 remains connected to package pin 11 304. Similarly, the functional view after the swap is shown in Fig. 4. Conductive strip 410 is shown connected to package pin 5 408 and conductive strip 420 is shown connected to package pin 6 412, both of which are the inputs to the AND gate 404.

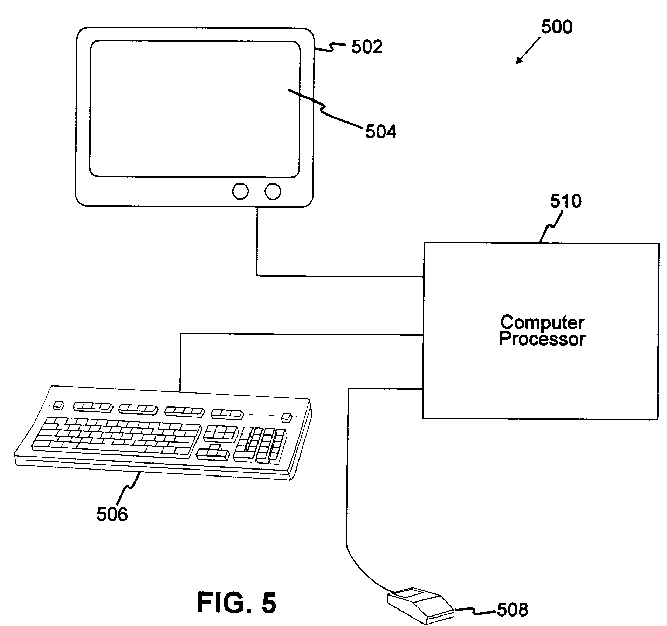

The display of functional views along with physical layout views can be accomplished using a general purpose computer system as shown in Fig. 5. Fig. 5 shows a general purpose computer system 500 comprising a graphical display monitor 502 with a graphics screen 504 for the display of graphical information, a keyboard 506 for textual entry of information, a mouse 508 for the entry of graphical data, and a computer processor 510. The computer processor 510 is connected to the graphical display monitor 502, the keyboard 506, and the mouse 508. Other graphical entry devices, such as a light pen or tracking ball, can be substituted for the mouse 508. This general purpose computer may be of a type. well known in the art such as a mainframe computer, a minicomputer, a workstation, or a personal computer. In one embodiment of the invention the computer processor contains program code to implement a conventional CAD system which contains capabilities for placement, routing, and other tasks associated with physical design of circuits along with program code to implement the aspects of the invention.

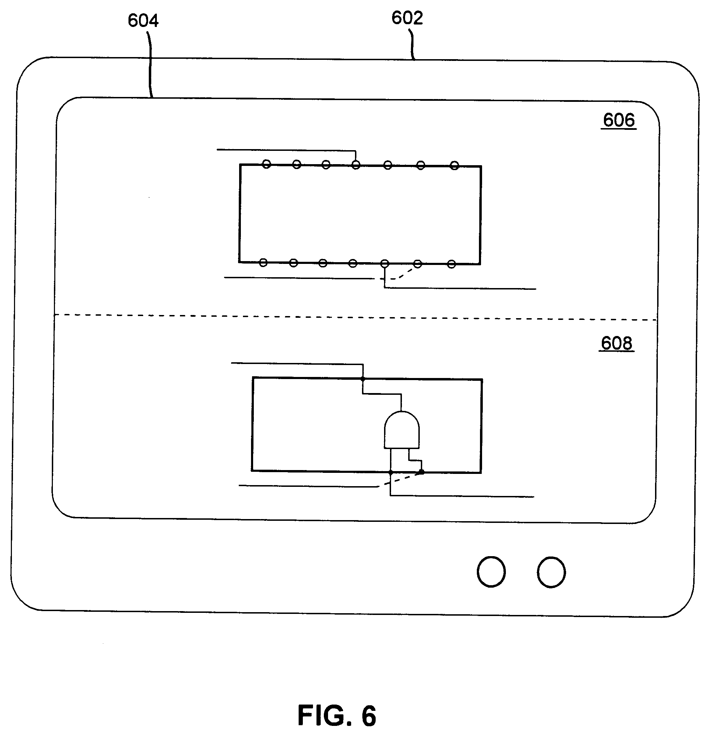

In accordance with one embodiment of the present invention a functional view of a circuit is displayed simultaneously with the physical layout view of the circuit on separate portions of the computer graphic screen. An example of this is shown in Fig. 6. Fig. 6 shows a graphics display monitor 602 with a display screen 604. One portion of the display screen 606 shows the physical layout view of the circuit. Another portion of the display screen 608 shows the functional view of the circuit. By displaying these two views simultaneously on the screen the circuit designer does not need to reference any external material, such as the schematic or component manufacturer's published specification of packages, in order to determine the functional characteristics of the components shown on the screen.

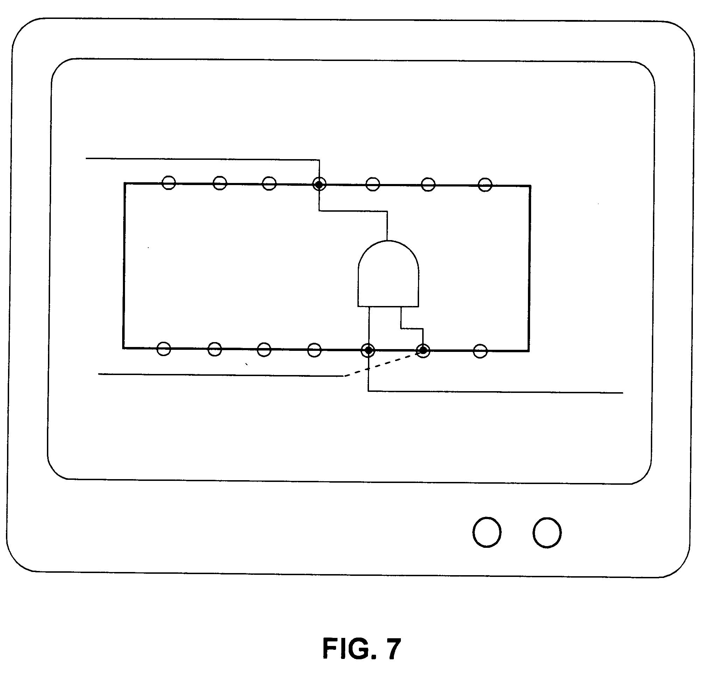

In accordance with an alternative embodiment of the present invention, a functional view is superimposed on the physical layout view on the computer graphics screen. This is illustrated in Fig. 7.

In a specific embodiment of the invention an algorithm is encoded in the stored program control of the CAD system in order to implement the invention described herein and to generate functional views of the components included in the repartitioning operation.

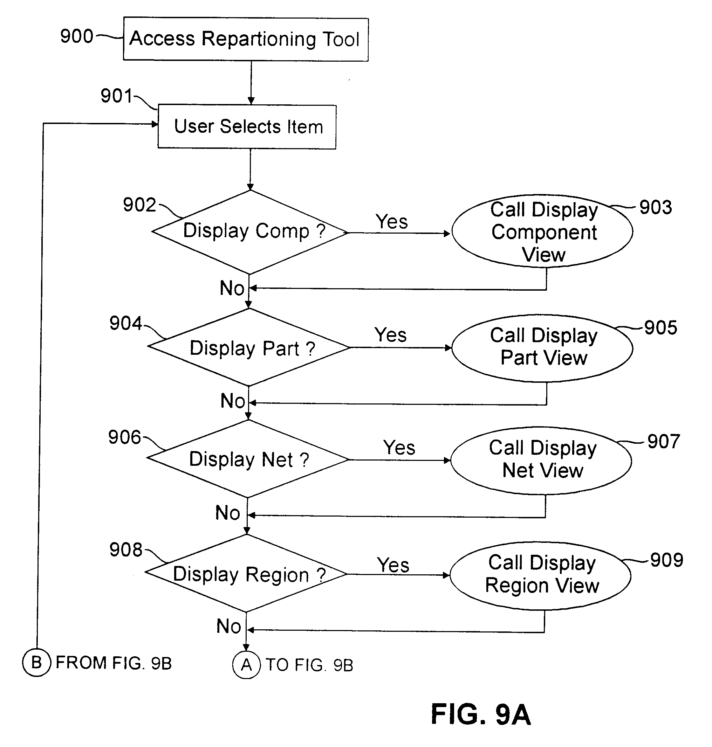

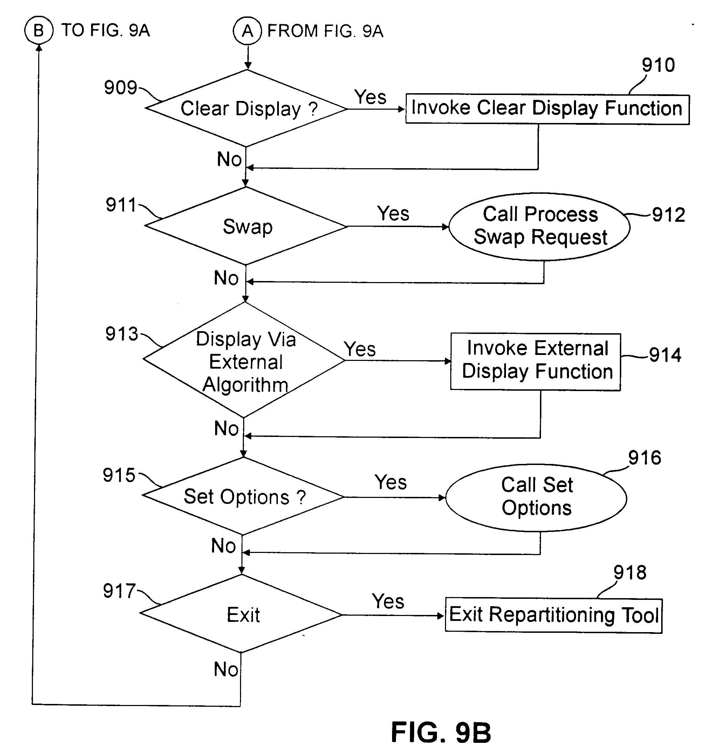

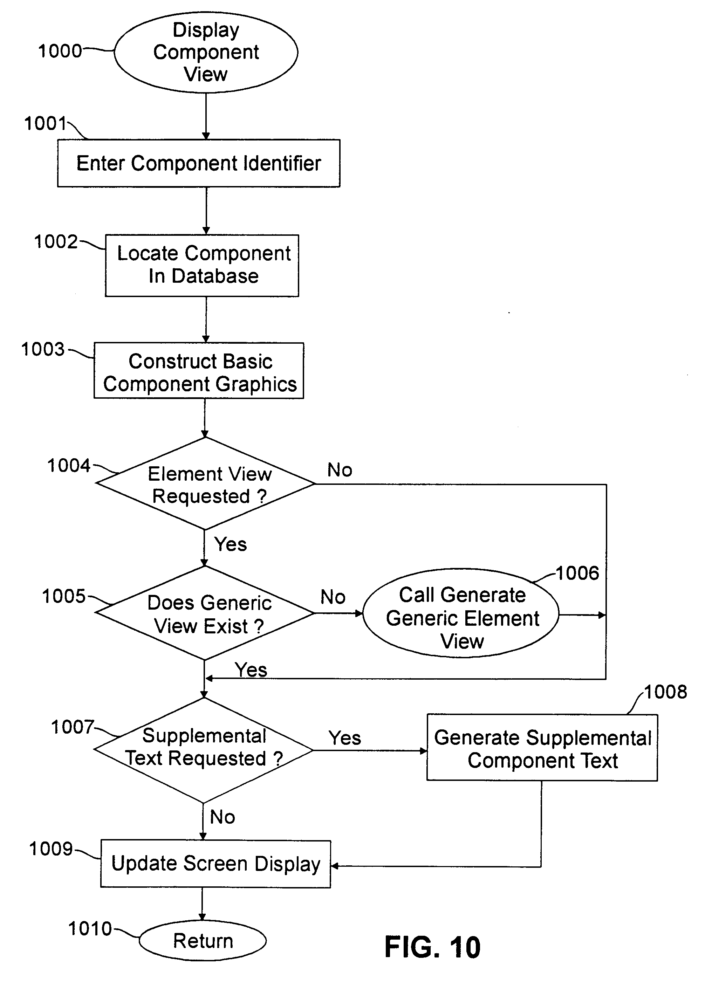

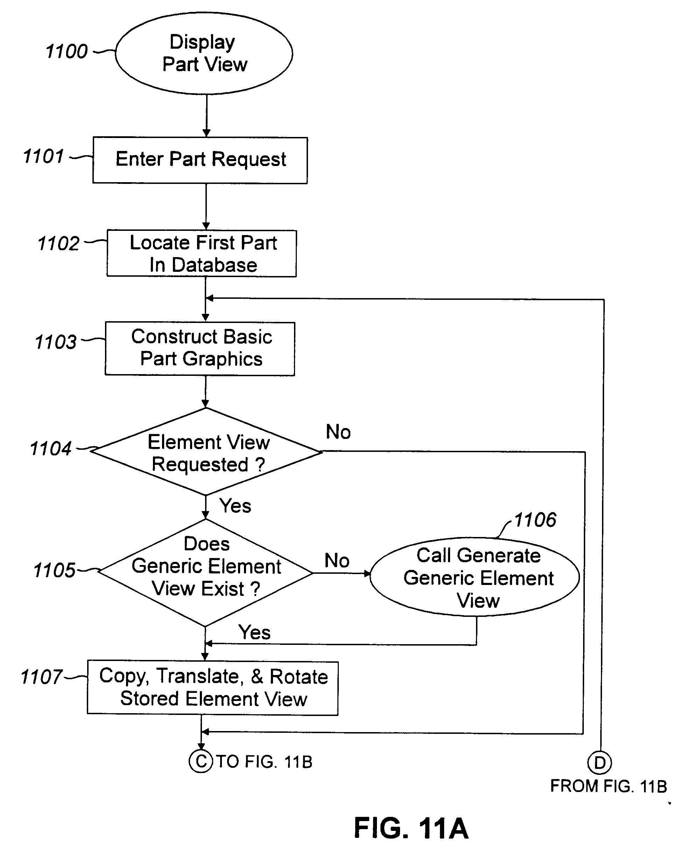

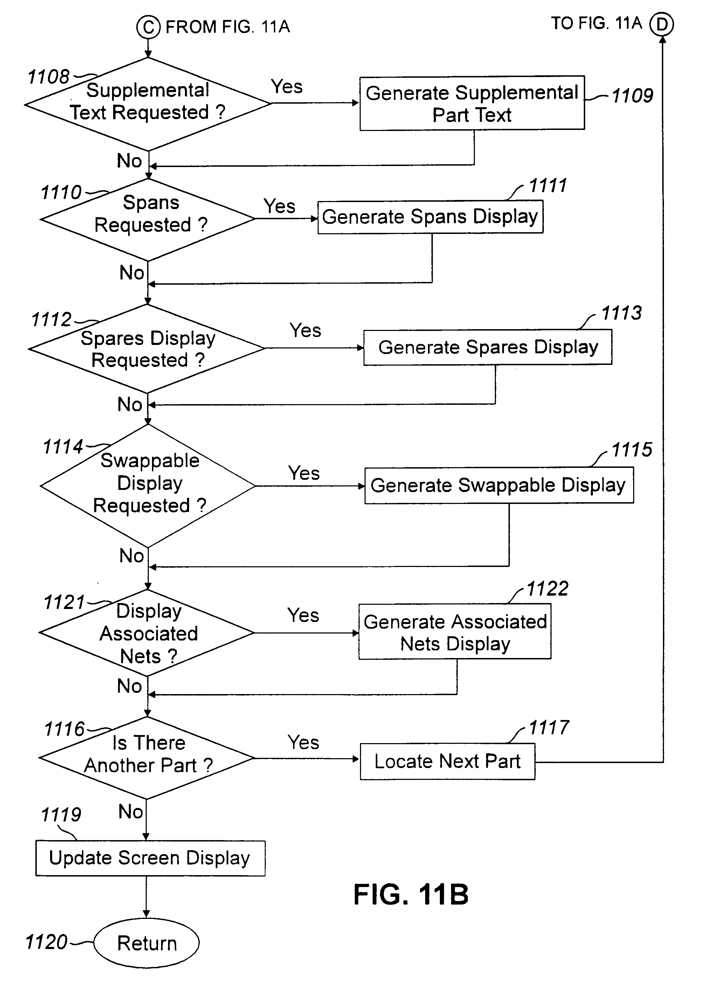

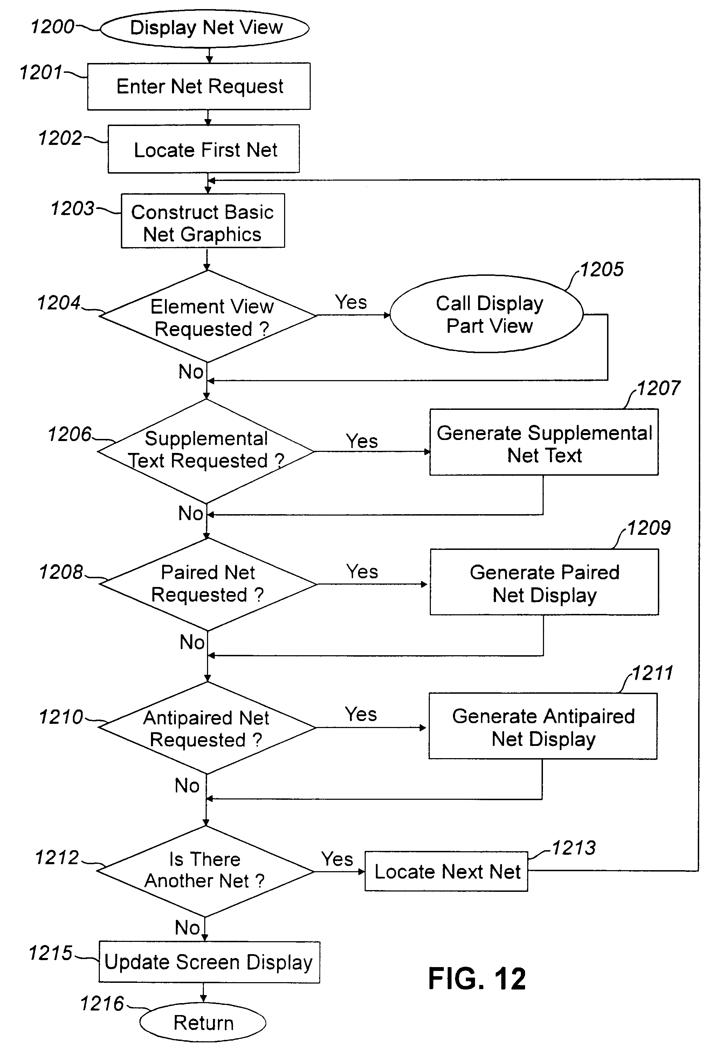

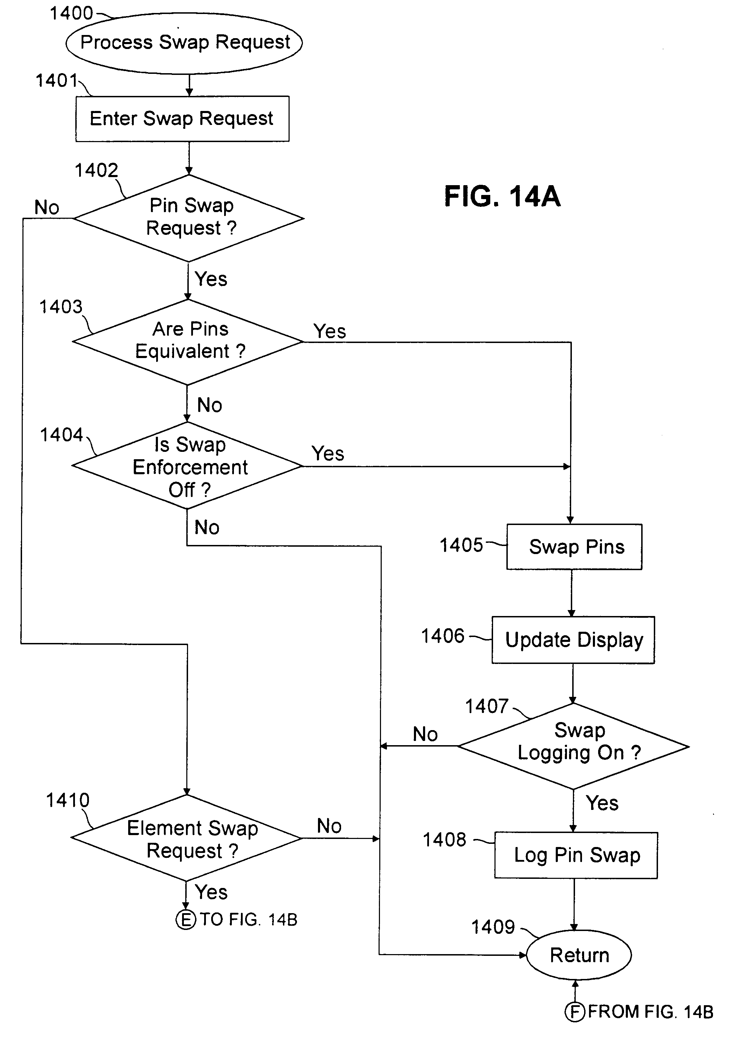

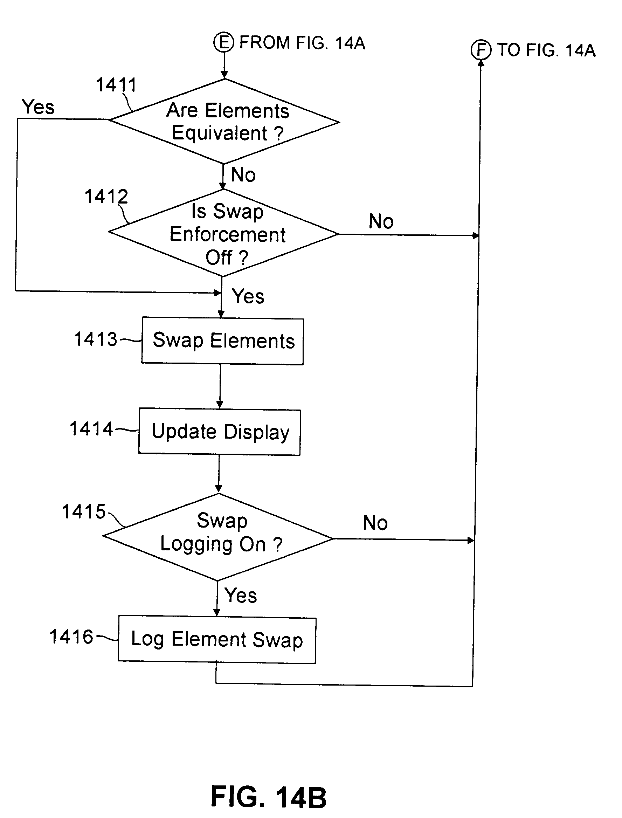

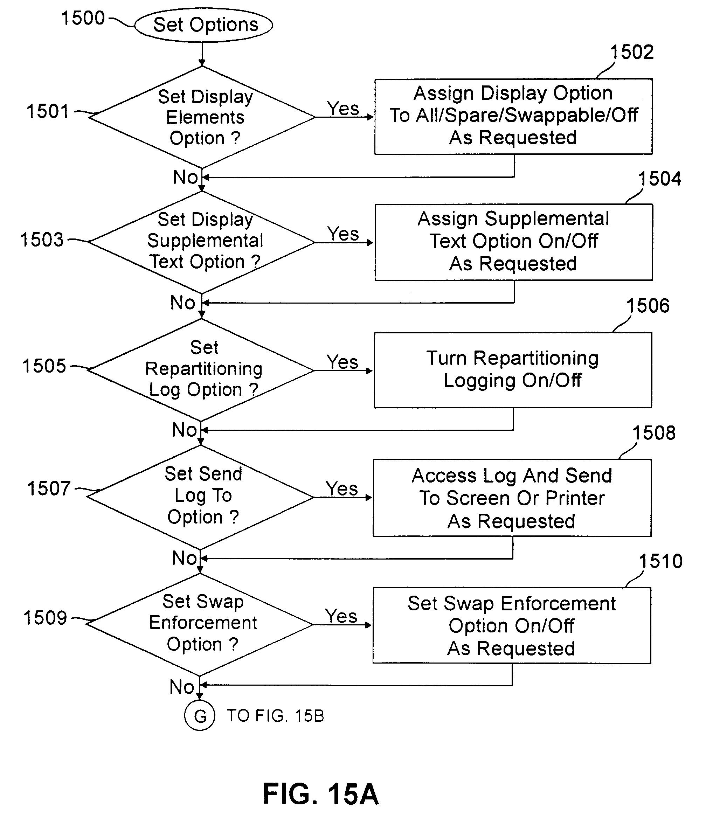

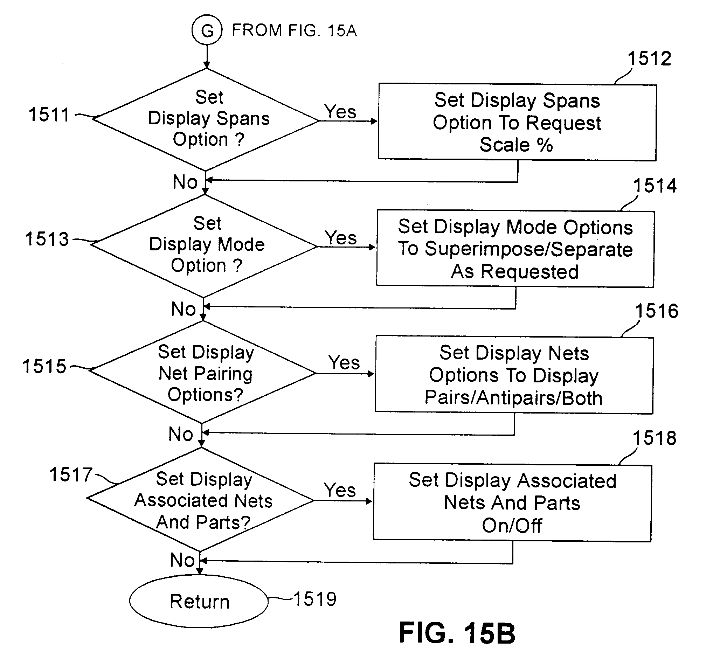

When invoked the Repartitioning Tool provides a set of capabilities. The operation of the user interface is described in Fig. 9 (Access Repartitioning Tool 900). The user selects an item from the menu in step 901. If the item selected is display component 902 then call Display Component View 903 (described below in conjunction with Fig. 10). If the item selected is display part , step 904, then call Display Part View 905 (described below in conjunction with Fig. 11). If the item selected is display net, step 906, then call Display Net View 907 (described below in conjunction with Fig. 12). If the item selected is display region, step 908, then call Display Region View 909 (described below in conjunction with Fig. 13). If the item selected is clear display, step 909, then invoke the clear display function in step 910. Successive requests for functional views will be superimposed until a clear display is requested. The clear display function is a routine graphics management capability which can be readily implemented by one skilled in the art of computer graphics. If the repartitioning view is in a separate area of the display then the entire display area may be erased. If the repartitioning view is superimposed on a physical layout view then only the repartitioning view may be deleted. If the item selected is Swap, step 911, then call Process Swap Request 912 (described below in conjunction with Fig. 14). If the item selected is display via external algorithm, step 913, then invoke external display algorithm as requested in step 914. Note that the external display algorithm is a program written outside of the main physical design system through a procedural interface to the database and screen management software. It provides the repartitioning tools with extensibility under the control of the user or a third party. If the item selected is set options, step 915, then call Set Options 916 (described below in conjunction with Fig. 15). If the item selected is Exit, step 917, then exit the repartitioning tools in step 918 and return to the parent menu in the physical design system. Else, loop back to step 901 to process another request.

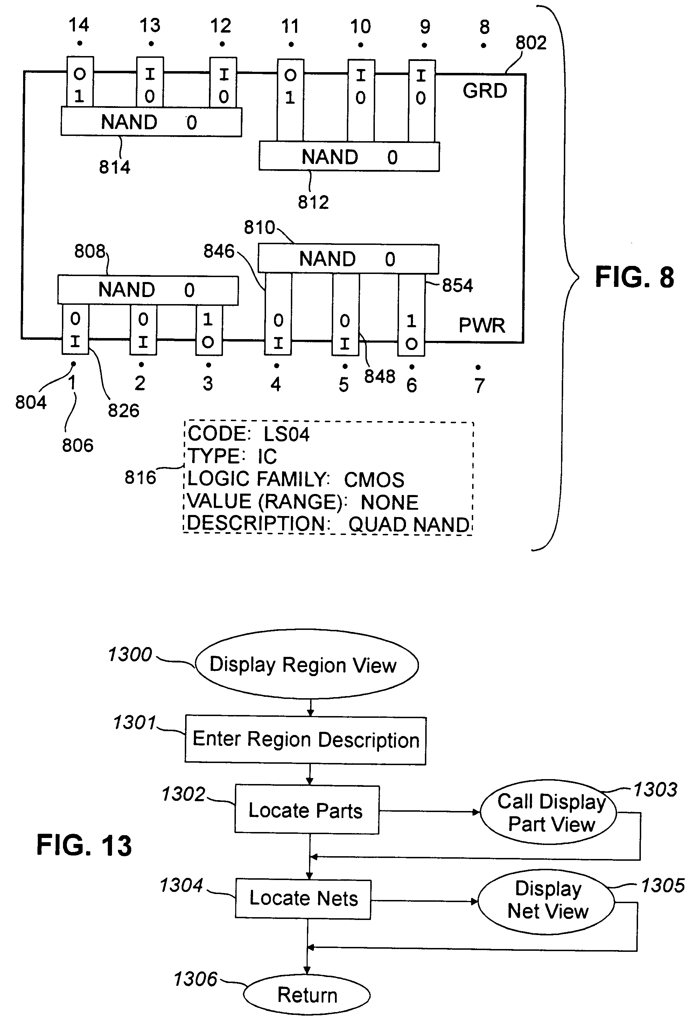

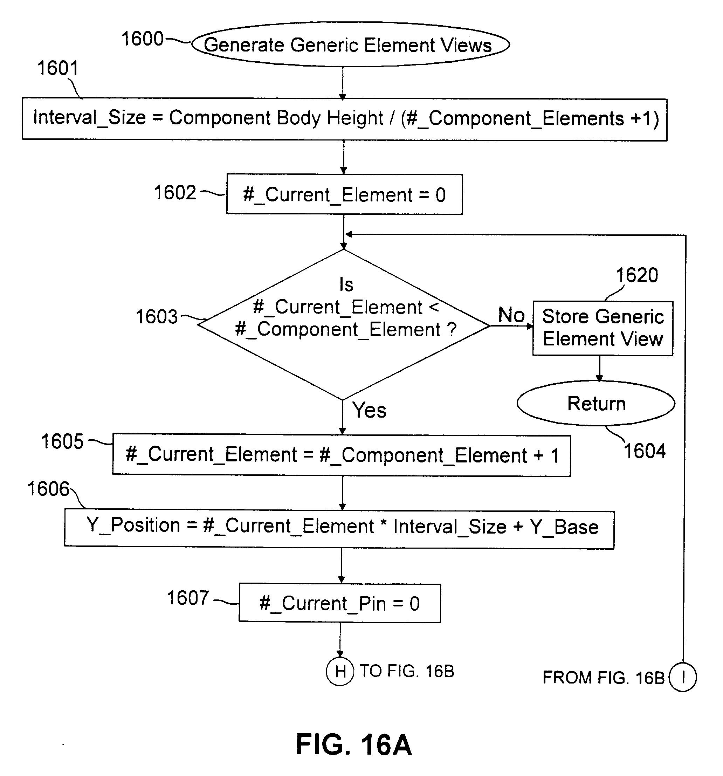

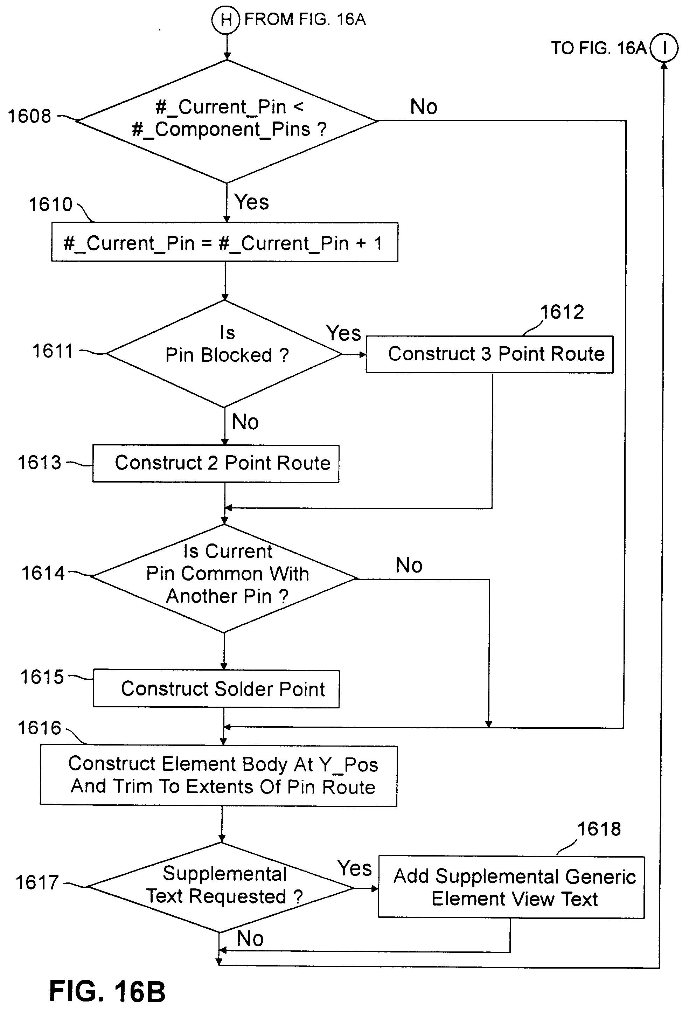

Component Views are processed at Display Component View 1000 (Fig. 10). The term component is used here to refer to a generic description of a packaged device or set of devices which are commercially available, such as 3 NAND gates in a dual in-line package. A component identifier is entered by the user in step 1001. This identifier is used to locate the requested component in a database in step 1002. This database may be part of the CAD system or may be external to the CAD system. Based upon the data retrieved from the database, basic component graphics are constructed in step 1003. These basic component graphics are shown in Fig. 8 and may consist of body outline 802, pin locations 804, and pin numbers 806. The next step 1004 is to determine if an element view is requested, as per the Display Elements option (the setting of options is discussed below in conjunction with Fig. 15). If not then go to step 1007. If an element view is requested then check to see if a generic element view of the component exists in step 1005. For efficiency, the first time an element view is requested for a given component, it is generated and stored for quick access on subsequent requests (rather than regenerating it). Thus if the requested element view has already been generated and saved it does not need to be regenerated. If a generic element view does not exist then call Generate Generic Element View 1006 to generate it and save it for future use. Element views are shown in Fig. 8, and include the elements 808, 810, 812, 814 within the component body outline 802. The generation of these element views is discussed below in connection with Fig. 16 and the Generate Generic Element View procedure.

The next step 1007 is to determine if supplemental text is requested as per the Supplemental Text option. If yes, then add supplemental text in step 1008. Supplemental text consists of a further description of the component view, and may include component code, component type, component logic family, component value range, and component description as shown at 816 (Fig. 8). Supplemental text may also be added to more fully describe the component pins. For example, pin 826 has supplemented text specifying the pin type as "I" for input. Other designations may include "O": output; "NC": not connected; and "EE": electrically equivalent. Polarity may also be designated. Component pins may also be labeled as power (PWR) or ground (GRD).

In addition, supplemental text may be used to display equivalence IDs. An equivalence ID is an indication of which elements or element pins are equivalent, and therefore swappable. Elements or pins with the same equivalence ID's are swappable with each other. For example, elements 808, 810, 812, and 814, which are all NAND gates all have equivalence IDs of 0, which is shown within the outline of each element. This indicates that each of these elements is the equivalent of the other and therefore swappable with each other.

In addition, element pins may also have equivalence IDs. In Fig. 8, pins 846 and 848 of element 810 have equivalence IDs of 0, which are shown in the pin outline along with the pin types. Pin 854 of element 810 has an equivalence ID of 1. This indicates that pins 846 and 848 are swappable with each other, but not with pin 854. Note that element equivalence IDs are applicable to all elements in a component. However, pin equivalence IDs are only applicable within a specific element.

After supplemental text is generated, the screen is updated in step 1009 with the graphics generated (Fig. 10). Component views are always displayed in an area of the display screen separate from the layout area of the display screen. When completed return in step 1010.

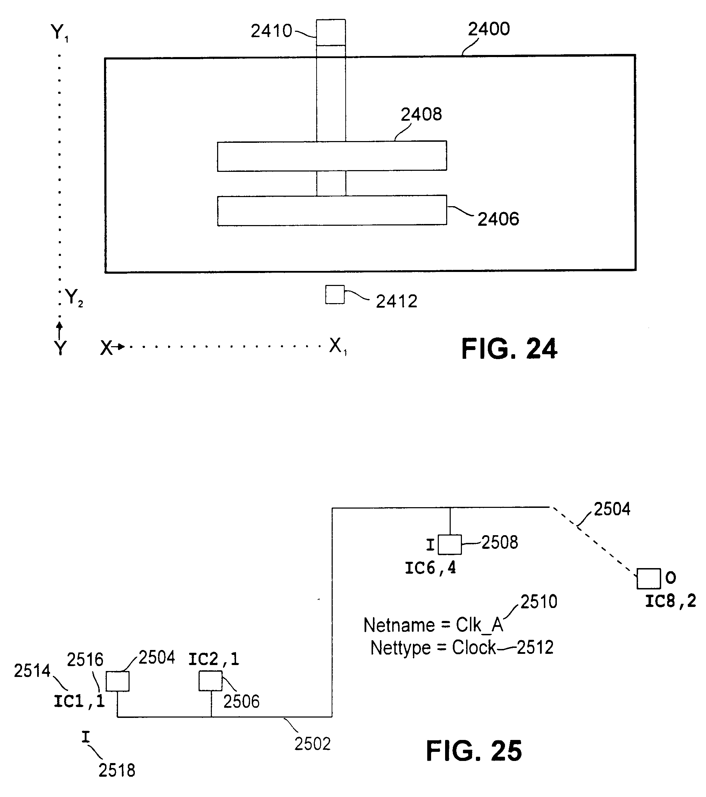

Part views are processed at Display Part View 1100 (Fig. 11). The term part is used to refer to an instance of a component. Thus, a component is the generic term used to describe a packaged device or set of devices. Once a component is placed in a PCB, it becomes a part with a unique part designation. A part request is entered in step 1101. Note that the request may be for a single part specified by its unique ID (e.g. IC1), a list of parts (e.g. IC1, IC2, IC3), or may be a request for all unrouted parts in the design. The first part matching the part request is located in the database in step 1102. Basic part graphics are constructed in step 1103 consisting of body outline, reference designation (unique ID such as IC1), locations and shapes of part terminal pads, and nomenclature (e.g., pin designators, polarity symbols). A basic part graphics display is similar to the basic component graphics display discussed in conjunction with Fig. 24. Determine if an element view is requested as per the Element View option in step 1104. If not, then go to step 1108. If an element view is requested then check to see if the generic element view exists for the component of which this part is an instance in step 1105. If it does not, then call Generate Generic Element View to generate it 1106. Copy, translate, and rotate the stored element view as needed in step 1107.

This step 1107 is required because the Generate Generic Element View procedure generates and stores a generic view of a component. Parts, which are instances of components may be placed anywhere within the physical layout of the circuit, and may be placed with various orientations (e.g., rotated 90°) with respect to the physical layout. Thus, prior to displaying a part within a physical or functional view on the display screen, the generic component view must be translated and rotated as needed to correspond to the part's orientation within the physical layout.

If supplemental text is requested as per the Supplemental Text option, step 1108, then generate supplemental text in step 1109, consisting of such additional information as the component name and type or netnames connected to the part pins. The supplemental text display for the part display is similar to the supplemental text display discussed in conjunction with Fig. 8. If spans are requested as per the Spans Option, step 1110, then generate spans as per the Spans Scale option in step 1111. A span is a conceptual representation of direct point to point connections between part terminals. When the spans scale option is set to zero then no spans are generated. When the spans scale option is set to 100% then full length spans are generated that show actual connections to other parts. If a number between 0 and 100 is specified then the spans are scaled back to the requested percentage of their full length. This permits a display to be generated which shows spans more like vectors indicating direction and magnitude and aid in determining desirable swaps. Generating the above described scaled spans display may be implemented by one skilled in the art by routine geometric manipulation.

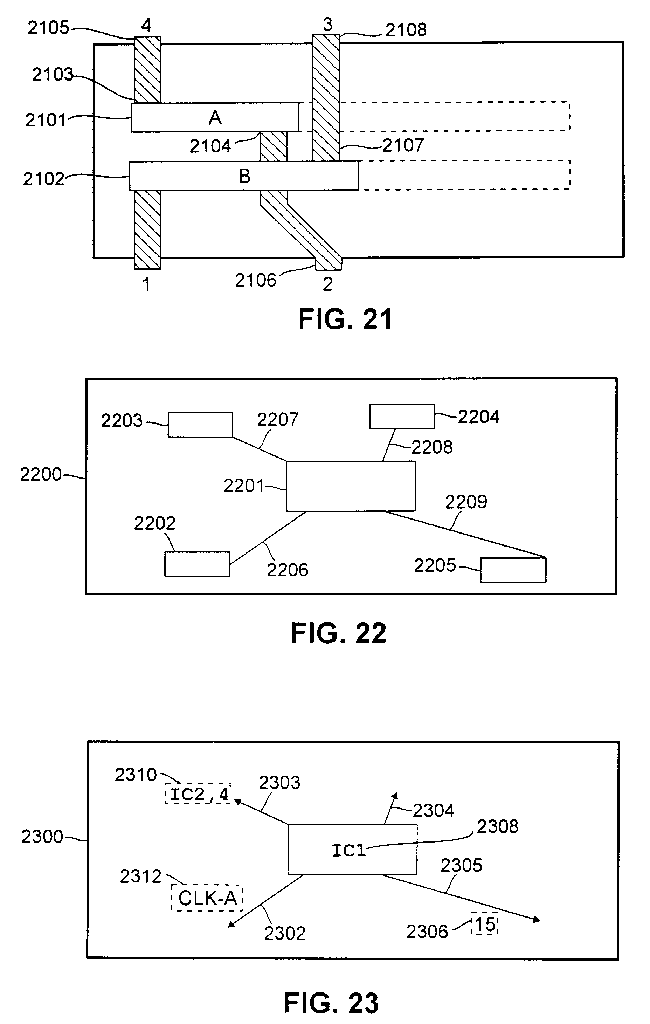

The spans option can be illustrated with reference to Figs. 22 and 23. Fig. 22 shows a portion of the display screen 2200 showing a spans display where the spans scale option is set to 100%. Spans are shown from part 2201. Full length spans 2206, 2207, 2208, 2209 show the connections to parts 2202, 2203, 2204, and 2205 respectively.

Fig. 23 illustrates the display screen where the spans scale option is set to a number less than 100%. Here, spans 2302, 2303, 2304 and 2305 are shown as a percentage of their full length. The scaled spans feature allows a user to more effectively analyze a small area of the design without having to view a representation of a large area of the design layout in the display screen which reduces the layout to a very small magnification. Scaled spans may also have supplemental information such as the length of the span 2306, a reference designation 2308, the part identifier and terminal number of the connection 2310, and the net name 2312.

Returning now to Fig. 11, if a spares display is requested as per the Display Elements option, step 1112, then generate a spares display in step 1113. The spares display shows the part views for each part which contains unused elements equivalent to elements in the part currently being processed. The system identifies these parts by scanning through a list of all the parts in the design. The system examines each element in each part to determine if an element equivalent to the element in the part being processed is available. For each part containing a spare element, the system will recursively call Display Part View 1100 to generate a display of the part. It is especially useful for finding unused elements to swap with elements in the current part.

If a swappable display is requested as per the Display Elements option, step 1114, then generate a swappable display in step 1115. The swappable display shows all parts which contain elements swappable with elements in the part being processed. The system identifies these swappable parts in a manner similar to discussed above in connection with the identification of spares. For each part containing a swappable element, the system will recursively call Display Part View 1100 to generate a display of the part. It is especially useful for finding elements to swap with elements in the current part.

If a display of associated nets is requested, step 1121, then generate an associated nets display in step 1122. The associated nets display shows each net associated with the part. The display of nets is described in more detail below in conjunction with Fig. 12.

If there is another part to process, step 1116, then locate the next part in step 1117 and go to step 1103 to process it. When all parts are processed the screen display is updated in step 1119. In one embodiment of the invention, the display screen will be updated to display the functional view of parts in a section of the display screen separate from the physical layout display. (See for example Fig. 6). In another embodiment, the screen will be updated so that the functional view is superimposed on the physical layout view. (See for example Fig. 7.) When completed return 1120.

Nets views are processed at Display Net View 1200 (Fig. 12). A printed circuit board net is defined as the set of element pins which are connected through part terminals externally to each part by electrically conductive interconnections. A net is shown in the graphical display by lines representing the conductive interconnections among the various circuit elements in the net. A net request is entered in step 1201. The net request may consist of a single net identifier, a list of net identifiers, all nets, nets with unrouted segments, nets that have been paired (designated to be routed near each other - e.g. parallel), and nets that have been antipaired (designated to be routed away from each other). The system maintains an ordered list of nets so that the nets may be located. Locate the first net matching the net request in step 1202. Construct basic net graphics in step 1203 consisting of routed segments, unrouted segments shown as spans, and part terminal graphics. Basic net graphics are shown in Fig. 25. The routed segment is shown by the solid line 2502. An unrouted segment is shown by broken line 2504. The part terminals are indicated by rectangles at 2504, 2506, 2508. If an element view is requested as per the Element View option in step 1204 then call Display Part View 1205 to process part views with element views for each part connected to the current net. If supplemental text is requested, step 1206, then generate supplemental text in step 1207 consisting of such items as netnames, terminal numbers, net types (power, ground, signal, clock, etc.), terminal types (input, output, ioput, power, ground), and reference designations for parts connected to terminals in the net. Supplemental text is shown in Fig. 25 as Netname = Clk_A 2510, Nettype = clock 2512, part reference designation = ICl 2514, terminal 1 2516, and terminal type = I (Input) 2518. If a paired net display is requested, step 1208, then generate a paired net display in step 1209. All nets that are flagged as paired with the current net will have net views generated for them. For each paired net located, the system will recursively call Display Net View 1200 to generate a display for the net. If an antipaired net display is requested, step 1210, then generate an antipaired net display in step 1211. All nets that are flagged as antipaired with the current net will have net views generated for them. For each antipaired net located, the system will recursively call Display Net View 1200 to generate a display for the net. If there is another unprocessed net that matches the net request, step 1212, then locate the next net in step 1213 and go to step 1203 to process it. When all nets have been processed then update the display in step 1215. As discussed in more detail above, depending upon the embodiment of the invention, the display may be updated in a portion of the screen separate from the physical layout view, or the display may be updated so that the functional view information is superimposed on the physical layout view. After the screen display is updated, return 1216.

Region views are processed at Display Region View 1300 (Fig. 13). A region description is entered in step 1301. This may consist of typed or graphically entered coordinates describing a polygon shaped area (most simply a rectangle) of the layout to have a functional view generated. All parts inside the region are located in step 1302 by scanning through a list of all parts in the design and determining whether each part is within the region. Views are generated for the parts by calling Display Part View 1303. All nets inside the region are located by scanning through the ordered list of nets and determining whether each net is within the region in step 1304. Views are generated for the nets by calling Display Net View 1305. Return 1306.

Swap requests are processed at Process Swap Request 1400 (Fig. 14). A swap request is entered in step 1401 by textually describing the swap (e.g., swap IC1 element A with IC2 element B) or by graphically pointing to the elements on the screen. If the physical layout view and the functional view are in separate portions of the graphical display, changes can be indicated in either view. If changes are indicated in the functional view, the change will be made in the CAD system and the display will be updated in both the functional view and the physical layout view. Similarly, if the change is indicated in the physical layout view, the change will be displayed in the functional view as well. Thus, this embodiment of the present invention is fully integrated with the CAD system. If the invention is embodied in a system in which the functional views are superimposed on the physical layout view, then the change is indicated in the single display area. Here we see an aspect of how repartitioning views aid in repartitioning. By having a graphical display of the elements inside the parts on the display not only do they aid in determining which swaps to make but also aid in the actual description of the request to perform the swap. If a pin swap is requested, step 1402, then check if the pins are equivalent (and therefore swappable) in step 1403. If they are not then check to see if the Swap Enforcement option is off in step 1404. Swap enforcement is an option which, if set, will only allow swaps of pins which are equivalent. If the pins are equivalent or swap enforcement is off then perform the swap (i.e., update the net list to reflect the swap) in step 1405, update the display in step 1406 (including any spans currently on the display). After the swap is performed check if swap logging is on as per the Swap Logging option in step 1407. Swap logging is an option which allows the user to keep a record of the swaps which have been made. If swap logging is on then add an entry in the swap log for this pin swap in step 1408. The entry contains information such as the date and time of the swap, the pins swapped, and the user who performed the swap. Return 1409. If an element swap is requested, step 1410, then check if the elements are equivalent in step 1411. If they are not check if swap enforcement is off in step 1412. If swap enforcement is off or the elements are equivalent then perform the swap in step 1413 and update the display in step 1414 else return 1409. If swap logging is on, step 1415, then add an entry to the swap log for this element swap in step 1416 and return 1409.

Setting options is performed at Set Options 1500 (Fig. 15). If the Set Display Elements Option is selected, step 1501, then assign appropriate value to option as requested in step 1502. If Set Display Supplemental Text Option is selected, step 1503, then assign appropriate value to option as requested in step 1504. If the Set Repartitioning Log Option is requested, step 1505, then turn repartitioning logging on or off as requested in step 1506. If the Set Send Log To Option is selected, step 1507, then access the log and send it to the screen or printer as requested in step 1508. If the Set Swap Enforcement Option is selected, step 1509, then assign the appropriate value to the option as requested in step 1510. If the Set Display Spans Option is selected, step 1511, then assign the appropriate value to the option in step 1512. If the Set Display Mode Option is selected, step 1513, then assign the appropriate value to the option as requested in step 1514. If the Set Display Net Pairing Option is selected, step 1515, then assign the appropriate value to the option in step 1516. If the Set Display Associated Nets and Pairs Option is selected, step 1517, then assign the appropriate value to the option in step 1518. Return 1519.

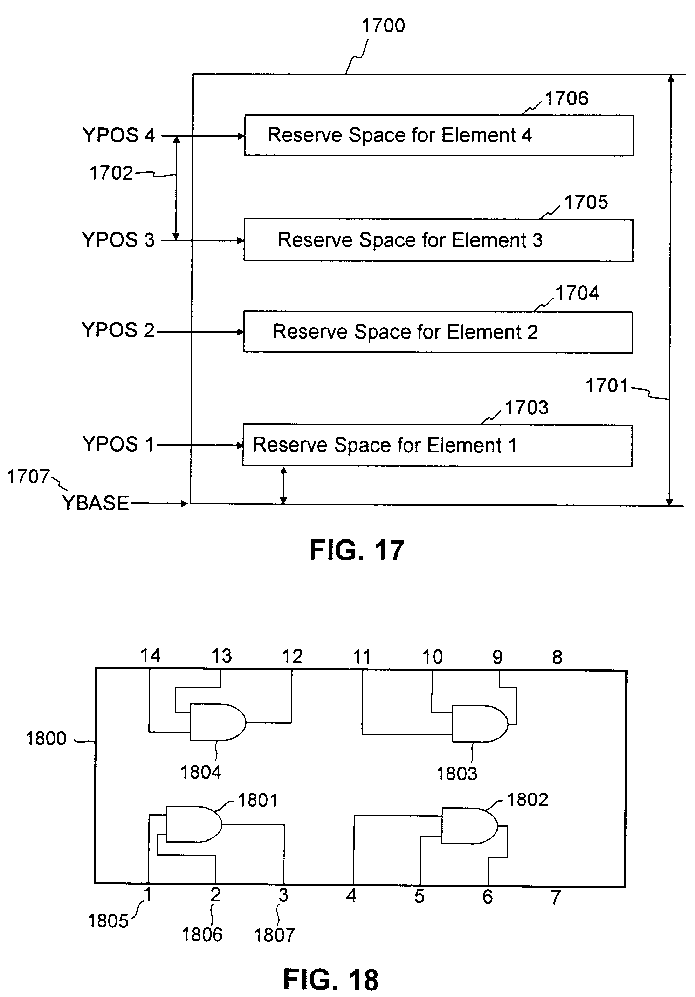

Generic Element Views are generated at Generate Generic Element View 1600 (Fig. 16). For dual in-line packages (DIPS) and single in-line packages (SIPS), Fig. 17 shows a representation of the internal view of a package. For the requested component take the component height 1701 and divide this by the number of elements in this component (#_Component_Elements) plus one in step 1601. The result is an interval size 1702 that will be used to allocate slots 1703, 1704, 1705, 1706 within the display of the physical package 1700. This interval size 1702 is the distance between reserve space centers. Each element defined to be contained within this component will now be added to the geometric description of the display. Assign zero to #_Current_Element in step 1602. If #_Current_Element is not less than #_Component_Elements, step 1603, then the picture is complete. Store the generic element view in step 1620 in the system. This storage of generic element views allows for the later use of this view without the need to regenerate it. Return 1604.

If #_Current_Element is less than #_Component_Elements, step 1603, then there is a next element to process. Increment #_Current_Element by one in step 1605. The geometric description for the next element is now constructed. The number of the current element being processed is multiplied by the interval size 1702 and a y-axis base (ybase) 1707 is added to this in step 1606. As shown in Fig. 17, ybase 1707 represents the lower horizontal base of the component package 1701. In terms of a graphical display, ybase is also defined as the minimum y coordinate of the component package. The result of the calculation in step 1606 called Y_Position (YPOS) specifies the y-axis position of the current element being processed (YP0S1, YP0S2, YP0S3, YP0S4). Next, each pin of the current element is processed. Assign zero to #_Current Pin in step 1607. If #_Current_Pin is less than the number of pins in the current element being processed (#_Component_Pins), step 1608, then there is a next pin to process, else go to step 1616. Increment #_Current_Pin by one in step 1610.

Determine if this pin is blocked (i.e., the two point connection between the element pin and the package pin is not clear) in step 1611, because it is possible that another element previously added to the geometric description of the display has already utilized part of the space that this current route would occupy. The system determines whether a pin is blocked as described here in conjunction with Fig. 24. With reference to the component body 2400, consider a coordinate system with an x and y coordinate system. An element already added to the display is shown as 2406, and the current element being added is shown as 2408. A blockage exists if the x coordinate of a pin of an existing element is the same as the x coordinate of a pin of the element being added, and if the y coordinate of the pin of the existing element is greater than the y coordinate of the pin of the element being added. As shown in the diagram, element 2406 shows a connection to pin 2410. The x coordinate of pin 2410 is shown as x₁. The y coordinate of pin 2410 is shown as y₁. Assuming the element to be added 2408 has a connection to pin 2412, then according to the test described above there is a blockage. This is so because the x coordinate of pin 2412 is x₁, the same as the x coordinate of pin 2410. Also, the y coordinate of pin 2410 is y₁ which is greater than the y coordinate if pin 2412 which is y₂.

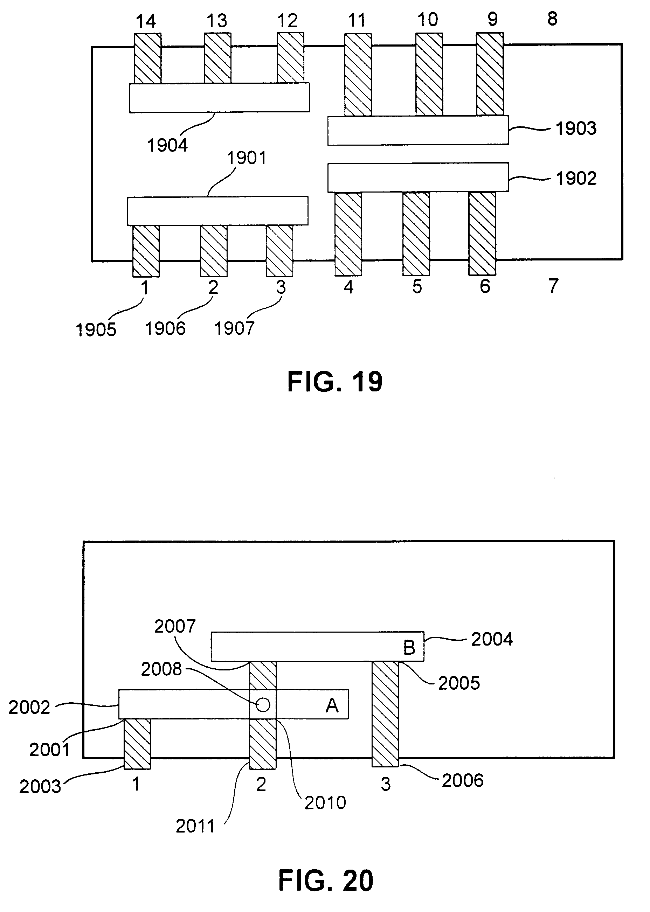

Returning now to Fig. 16, if there is no blockage construct and add a two point route (connecting line) between the element body and package pin in step 1613. If there is a blockage then construct a three point route which is offset so as to avoid the area of route contention in step 1612. The display of two and three point routes are described in more detail below in conjunction with Fig. 21. Determine if this pin is common with another pin in step 1614. This means that two elements have pins that are connected to the same package pin. This is accomplished by looking at all pins of all elements which have previously been added to the display and determining if any of those pins connect to the same component package terminal as the current pin. If there is no other pin common with the current pin then proceed to step 1616. If there is another element pin common with the current element pin then construct a "solder point" in the geometric display in step 1615. This "solder point" is a notation at the point where the two routes intersect indicating that they are common. The display of a solder point is described in more detail below in conjunction with Fig. 20. The element body is now constructed as a rectangle for SIPs and DIPs at the appropriate YPOS using the reserve space running the entire extents of the component package in step 1616. The element body is trimmed to only extend across those sections of the package that this element has connections to. The trimming of element bodies is shown in conjunction with Fig. 21, discussed below. If supplemental text is requested as per the Supplemental Text option, step 1617, then add descriptive text for element names, pin and element equivalence IDs, power pins, ground pins, and unused pins in step 1618. Go to step 1603 to process the next element in this component.

The generation of generic element views for DIPS is further illustrated with reference to Figs. 18-21. Fig. 18 shows a package 1800 which contains four AND gates 1801, 1802, 1803, 1804. Each of the AND gates has two inputs and one output. For example, gate 1801 has two inputs from package pins one and two 1805, 1806, and one output at package pin 3 1807. Each of gates 1802, 1803 and 1804 are similarly constructed. As discussed above, data describing such a component package would be included within a system database or accessed on-line from an accessible stored database. The information specified would include physical package geometry (including length and width of package), number and location of component package pins, and the optional identification of power, ground, and unused pins. In addition, a description of each element contained in this package including the number of elements, the number of element pins, the association of element pins to component package pins and optionally each element is defined as to name or type. No geometric description is needed or used for the elements or the internal view of the elements within the component package. This is generated dynamically by the invention, as described above. This avoids the costly and time consuming task of manually producing these geometric descriptions.

The above information would be used to generate a display as shown in Fig. 19. The process for generating Fig. 19 is discussed above in connection with the Generate Generic Element View procedure 1600 (Fig. 16). Fig. 19 shows the geometric description of the package shown in Fig. 18, which would be displayed on the computer graphic screen. Each of the AND gates, 1801, 1802, 1803, 1804 are represented by the rectangles 1901, 1902, 1903, 1904 respectively. In addition to these element views, supplemental text may be displayed, as discussed above in conjunction with Fig. 8.

Fig. 20 illustrates the representation of a "solder point" in the geometric display. In this illustration, pin 1 2001 of element A 2002 is connected to package pin 1 2003. Similarly, pin 2 2005 of element B 2004 is connected to package pin 3 2006. Pin 1 2007 of element B 2004 and pin 2 2010 of element A 2002 are both connected to package pin 2 2011. This common connection is indicated by a solder point 2008 in the graphical display. The absence of a solder point would indicate no electrical connection. For example, Fig. 21 shows pin 1 2104 of element A 2101 connected to package pin 2 2106. Note that the connecting route passes through element B 2102, but there is no solder point. In this situation, the lack of a solder point indicates that there is no electrical connection between the connecting route and element B 2102.

Fig. 21 also illustrates the distinction between the graphic display of a two-point route and a three-point route between an element pin and package pin. In Fig. 21, pin 2 2103 of element A 2101 is connected to package pin 4 2105. Since there is no blockage this connection is made with a two-point route. In contrast, pin 1 2104 of element A 2101 needs to be connected to package pin 2 2106. As can be seen, this route is blocked by element B 2102 and the connection from pin 2 2107 of element B 2102 to package pin 3 2108. Thus, this connection must be made with a three-point connection which is offset so as to avoid the area of route contention.

Fig. 21 also illustrates the trimming of element bodies. The dotted areas of elements A and B 2101, 2102 indicate areas which have been trimmed and are not included in the display. As explained above, the element body is trimmed to only extend across those sections of the package that the element has connections to. This makes the resulting functional view clearer and easier to read.

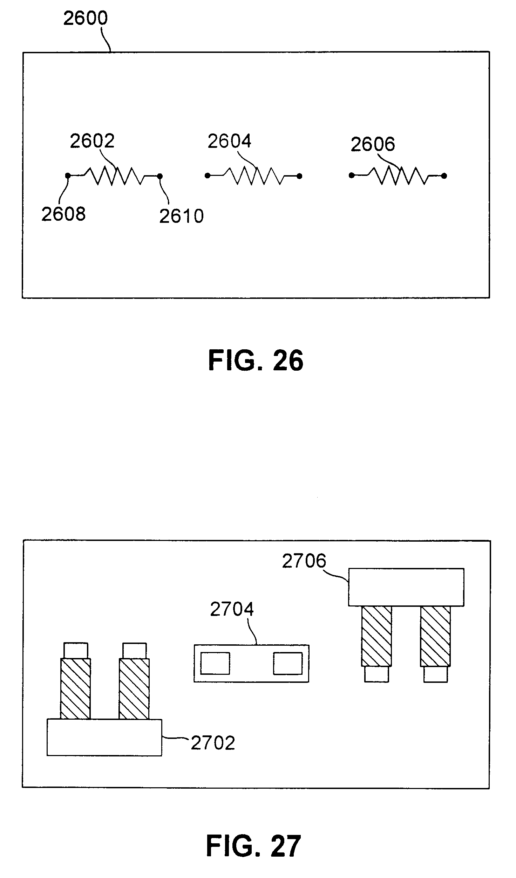

The generation of generic element views for SIPS is illustrated in Figs. 26-27. Fig. 26 shows a single in-line package 2600 which contains three resistors 2602, 2604, 2606. Each resistor is connected to two package terminals. For example, resistor 2602 is connected to package terminals 2608 and 2610. The process for generating generic element views as discussed above in conjunction with Fig. 16 would result in a display as shown in Fig. 27, which would be displayed on the computer graphics screen. Each of the resistors 2602, 2604, 2606 are represented by the rectangles 2702, 2704, 2706.

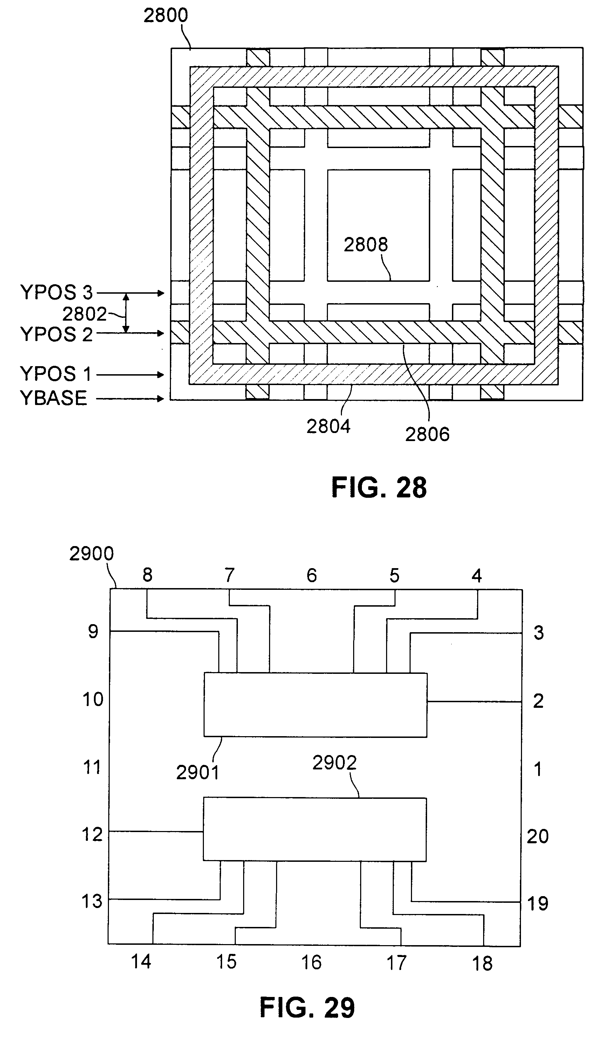

The generation of generic element views for leaded chip carriers (LCC's) is described with reference to Figs. 28-31. The procedure described in conjunction with Fig. 16, with the modifications described below, will produce a generic element view for LCC's. The interval size for LCC's is calculated the same as for SIPS and DIPS, and is illustrated in Fig. 28 at 2802. The interval size 2802 is used to allocate reserve space for the elements in the package. For LCC's, the reserve space for elements are different than for DIPS and SIPS. The reserve space for element 1 is shown at 2804, the reserve space for element 2 is shown at 2806, and the reserve space for element 3 is shown at 2808. Reserve space for additional elements in the LCC would continue with the same pattern.

Steps 1611 and 1612 of the Generate Generic Element View procedure are not necessary when generating views for LCC's because blockages do not occur in LCC's. The reserve space for elements in LCC's is four connected lines as described above in conjunction with Fig. 28. Element pins are routed to package pins from the nearest side of the reserve space, thereby eliminating blockages.

Fig. 29 shows a dual flip-flop packaged in an LCC. The package 2900 contains two flip-flops 2901, 2902. Flip-flop 2901 has connections to package pins 2, 3, 4, 5, 7, 8 and 9. Flip-flop 2902 has connections to package pins 12, 13, 14, 15, 17, 18 and 19. Further details of the elements are not necessary for the present description.

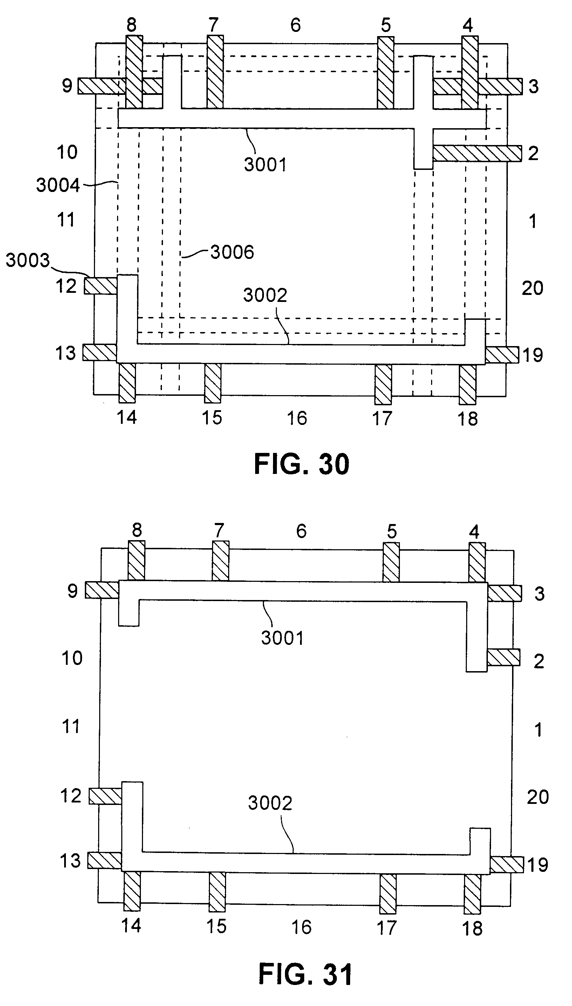

The Generate Generic Element View procedure 1600 would generate the display as shown in Fig. 30. The two flip-flops are shown as 3001 and 3002. Connections to package pins are shown by the connecting lines (e.g., 3003). Note that the view of flip-flop 3002 is constructed in the reserve space for element one 2804 (Fig. 28), and the view of flip-flop 3001 is constructed in the reserve space for element two 2806 (Fig. 28). The area 3004 represented by dotted lines represents the area of reserve space for flip-flop 3002 that was trimmed (step 1616, Fig. 16), and the area 3006 represented by dotted lines represents the reserve space for flip-flop 3001 that was trimmed.

An improved representation of functional views for LCC's can be achieved by a modification to step 1616 in which the element body is constructed and trimmed. This improved functional view is accomplished as follows. For each new element being constructed, check if any previous element utilized the portion of reserve space for element one which would be needed for the current element if it were also to use the reserve space for element one. If the needed area of reserve space of element one is free, then use it. Otherwise, use the reserve space for the current element being processed. This results in the improved functional view of Fig. 31 for the package shown in Fig. 29.

Fig. 31 shows views of the two flip-flops 3001 and 3002. However, in Fig. 31, as compared to Fig. 30, both flip-flops use the reserve space for element 1. In Fig. 31, flip-flop 3001 is able to use the reserve space for element one which was not used for flip-flop 3002. The result is an improved functional view as it contains less lines and is easier to interpret.

Thus, it is seen that the Generate Generic Element View procedure described in conjunction with Fig. 16 generates functional views for DIPS and SIPS. The same procedure, with the above described modifications, also generates functional views for LCCs.

As a further embodiment, this invention may be used in the context of compiling and administrating a database catalog containing information on various components. There is a large number of components which are manufactured by various manufacturers. Circuit designers generally need to keep a database containing the data supplied by the manufacturer for various components as this eliminates the need to redundantly enter this information. Data entry clerks enter a large amount of textual data into the catalog system. The present invention may be used to generate graphical displays of each component using the data that has been entered. This allows the catalog administrator to check the integrity of the data that has been entered by viewing a graphical display generated by the present invention. This use of- the present invention also allows the catalog to contain a graphical representation of the component without having to optically scan the manufacturer's representation of the components internal logic view into the database and without having to manually generate a graphical representation.

In another embodiment, this invention may be used in connection with automatic swapping algorithms. Such algorithms automatically determine which swaps will be beneficial to the design and carry them out. These algorithms are highly complex and therefore, very difficult to debug. It is possible to run these programs in a debug mode where a display is generated for each swap as it is being made on a graphical display screen. However, if only a physical layout view is shown on the display screen it is difficult for a circuit designer to follow the algorithm while it is running and determine whether the swaps that are being made are beneficial or correct. By using the present invention to display functional views during execution of an automatic swapping algorithm, the circuit designer can view the execution of the algorithm and can determine whether the swaps that are being made are beneficial. The invention enables the programmer or end user to more easily and readily visually associate functional swappability data with the physical layout display.

It is to be understood that the embodiments and variations shown and described herein are illustrative of the principles of this invention only and that various modifications may be implemented by those skilled in the art without departing from the scope and spirit of the invention.

## Claims

1. A graphical display system for use in repartitioning circuits during layout comprising:
a computer processor;
a graphical display monitor connected to the computer processor;
graphical data entry means connected to the computer processor;
means for displaying a physical layout view of a circuit on the graphical display monitor;
means for generating a functional view of at least a portion of said circuit; and
means for displaying said functional view and said physical layout view on the graphical display monitor simultaneously.

2. The system of claim 1 further comprising:
means for displaying said physical layout view in a first section of said graphical display monitor; and
means for displaying said functional view in a second section of said graphical display monitor.

3. The system of claim 1 further comprising:
means for superimposing said functional view on said physical layout view.

4. The system of claim 1 wherein said graphical data entry means is used to indicate items to be swapped, said system further comprising:
means responsive to said indication of items to be swapped for swapping said items in the graphical display system;
means for displaying said swap in said physical layout view; and
means for displaying said swap in said functional layout view.

5. The system of claim 4 further comprising:
means for determining whether the indicated items to be swapped are equivalent and if they are not equivalent, rejecting the requested swap and indicating on the graghical display monitor that the requested swap cannot be made.

6. The system of claim 4 further comprising:
a swap log for recording swaps; and
means for recording swaps in said swap log.

7. A graphical display system for the display of component packaging information comprising:
a computer processor;
a graphical display monitor connected to the computer processor;
data entry means connected to the computer processor for identifying a component;
means for accessing component information from a database;
means responsive to said component information for generating a functional view of the elements of said component; and
means for displaying said functional view on the graphical display monitor.

8. The system of claim 7 further comprising:
means for storing in the graphical display system the generated functional view of the elements of said component for fast access during subsequent requests for a functional view of the same component or instances of the same component.

9. The system of claim 7 further comprising:
means for generating a graphical display of a two point connection between an element pin and a package pin when the connection between the element pin and the package pin is not blocked;
means for generating a graphical display of a three point connection between an element pin and a package pin when the connection between the element pin and the package pin is blocked; and
means for displaying the two point connection or the three point connection on the graphical display monitor.

10. The system of claim 7 further comprising:
means for generating a graphical display of a solder point to indicate an intersection where two element pins are connected to a single package pin; and
means for displaying said solder point on the graphical display monitor.

11. A graphical display system for use in repartitioning circuits during layout comprising:
a computer processor;
a graphical display monitor connected to the computer processor for the display of graphical information;
means for displaying a physical layout of a circuit in said graphical display monitor;
a data entry device connected to the computer processor for identifying a part in the displayed physical layout;
means for accessing part information from a database;
means responsive to said part information for generating a graphical display of the functional elements of said part; and
means for displaying said graphical display of the functional elements of said part on the graphical display monitor.

12. The system of claim 11 further comprising:
means for displaying a straight line span from said identified part to a second part, said span representing a connection in the physical layout between said identified part and said second part.

13. The system of claim 11 further comprising:
means responsive to a user specified percentage for generating a straight line span;
said span representing a connection in the physical layout between said identified part and a second part;
said span being connected to said identified part and extending a length in a direction representative of the location in the physical layout of said second part; and
said length of said displayed span being the user specified percentage of the length in the physical layout between said identified part and said second part.

14. The system of claim 11 further comprising:
means responsive to a user specified request for generating a spares display, wherein said spares display identifies parts in the circuit which contain unused elements which are equivalent to the elements in said specified part.

15. The system of claim 11 further comprising:
means responsive to a user specified request for generating a swappable display, wherein said swappable display identifies parts in the circuit which contain elements which are equivalent to the elements in said specified part.

16. A graphical display system for use in repartitioning circuits during layout comprising:
a computer processor;
a graphical display monitor connected to the computer processor;
means for displaying a physical layout of a circuit on said graphical display monitor;
data entry means connected to the computer processor for identifying a net in said physical layout;
means for generating a graphical display of said identified net;
said graphical display of said identified net comprising;
a graphical view of said net;
a graphical view of the parts connected to said net; and
means for displaying said graphical display of said identified net in the graphical display monitor.

17. A graphical display system for use in compiling a database of electronic component information comprising:
a computer processor;
a display monitor connected to the computer processor, said display monitor capable of displaying graphical information;
a keyboard for the entry of textual and numerical data relating to electronic components;
means responsive to the textual and numerical data for generating functional views of said components; and
means for displaying said functional views on said display monitor.

18. A graphical display system for use in debugging an automatic swapping system comprising:
a computer processor;
a graphical display monitor connected to the computer processor;
means for displaying a physical layout view of an electronic circuit on said graphical display monitor;
computer program code executable on said computer processor for the automatic swapping of elements in the physical layout;
means for displaying on the graphical display monitor each automatic swap in the physical layout as it is made by the automatic swapping system;
means for generating a functional view of the physical layout;
means for displaying the functional view on the graphical display monitor; and
means for displaying on the graphical display monitor each automatic swap in the functional view as it is made by the automatic swapping system.

19. A method for repartitioning circuits during layout comprising the steps of:
displaying a physical layout of a circuit on a graphical display monitor;
generating a functional view of at least a portion of said physical layout; and
displaying said functional view on the graphical display monitor at the same time said physical layout is being displayed.

20. The method of claim 19 wherein:
said physical layout is displayed in a first section of said graphical display monitor; and
said functional view is displayed in a second section of said graphical display monitor.

21. The method of claim 19 wherein:
said functional view is superimposed on said physical layout on the graphical display monitor.

22. The method of claim 19 further comprising the steps:
specifying items of the circuit to be swapped using a graphical data entry device;
swapping said specified items;
displaying the results of said swap in said physical view; and
displaying the results of said swap in said functional view.

23. The method of claim 22 further comprising the steps:
determining whether said specified items to be swapped are equivalent; and
if said specified items to be swapped are not equivalent, rejecting said swap and indicating on the graphical display monitor that said swap cannot be made.

24. The method of claim 22 further comprising the steps:
recording said swap in a swap log.

25. A method for graphically displaying component packaging information in a computer aided design system comprising the steps:
displaying a physical layout of a circuit on a graphical display monitor;
identifying a component for which component packaging information will be displayed;
accessing component information from a database;
generating a functional view of the elements of said component from the component information accessed from the database; and
displaying said functional view on a graphical display monitor.

26. The method of claim 25 further comprising the step:
storing in the computer aided design system the generated functional view of the elements of the component; and
accessing said stored functional view and displaying it on a graphical display monitor when a subsequent request for a functional view of the same component is made.

27. The method of claim 25 further comprising the step:
generating a graphical display of a two point connection between an element pin and a package pin when the connection between the element pin and the package pin is not blocked;
generating a graphical display of a three point connection between an element pin and a package pin when the connection between the element pin and the package pin is blocked; and
displaying the two point connection or the three point connection on a graphical display monitor.

28. The method of claim 25 further comprising the step:
generating a graphical display of a solder point to indicate an intersection where two element pins are connected to a single package pin; and
displaying said solder point on the graphical display monitor.

29. A method for repartitioning circuits during layout comprising the steps of:
displaying a physical layout of a circuit on a graphical display monitor;
specifying a part on the physical layout by means of a data entry device;
accessing information related to the identified part from a database;
generating a graphical display of the functional elements of said part; and
displaying said graphical display of the functional elements of said part on the graphical display monitor.

30. The method of claim 29 further comprising the steps:
generating a straight line span from said specified part to a second part, said span representing a connection in the physical layout between said specified part and said second part.

31. The method of claim 29 further comprising the steps:
indicating a percentage for displaying a straight line span, said span representing a connection in the physical layout between said specified part and a second part;
displaying on the graphical display monitor a straight line span, said displayed span being connected to said specified part and extending a length in a direction representative of the location in the physical layout of said second part; and
said length of said displayed span being the indicated percentage of the length in the physical layout between said specified part and said second part.

32. The method of claim 29 further comprising the steps:
indicating a request for generating a spares display; and
displaying a spares display on the graphical display monitor, said spares display identifying parts in the circuit which contain unused elements which are equivalent to the elements in said specified part.

33. The method of claim 29 further comprising the steps:
indicating a request for generating a swappable display; and
displaying a swappable display on the graphical display monitor, said swappable display identifying parts in the circuit which contain elements which are equivalent to the elements in said specified part.

34. A method for repartitioning circuits during layout comprising the steps of:
displaying a physical layout of a circuit on a graphical display monitor;
identifying a net in the physical layout by means of a data entry device;
generating a graphical display of said identified net comprising:
a graphical view of said net; and
a graphical view of the parts connected to said net; and
displaying the graphical view of said identified net on the graphical display monitor.

35. A method for compiling and maintaining a database of electronic component information the steps comprising:
entering textual and numerical data relating to electronic components into a computer database;
generating functional views of the components using said textual and numerical data;
displaying said functional views on a graphical display monitor.

36. A method of debugging an automatic swapping system comprising the steps:
displaying on a graphical display monitor a physical layout view of a circuit;
executing a computer program for the automatic swapping of circuit elements on a computer;
displaying on the graphical display monitor each automatic swap in the physical layout as it is made by the automatic swapping program;
displaying a functional view of the physical layout on the graphical display monitor; and
displaying on the graphical display monitor each automatic swap in the functional view as it is made by the automatic swapping program.
